# EUROPÄISCHE PATENTSCHRIFT

(11) **EP 3 479 070 B1**
(45) Veröffentlichungstag und Bekanntmachung des Hinweises auf die Patenterteilung: **18.08.2021**
(21) Anmeldenummer: 17730126.4
(22) Anmeldetag: 12.06.2017
(51) Int. Cl.: G01D 5/20, G01D 5/243

(54) **SPULENANORDNUNG UND ZUGEHÖRIGE MESSANORDNUNG**
COIL ASSEMBLY AND CORRESPONDING MEASURING ASSEMBLY
ENSEMBLE BOBINE ET SYSTÈME DE MESURE ASSOCIÉ

(30) Priorität: 30.06.2016 DE 102016211981
(43) Veröffentlichungstag der Anmeldung: 08.05.2019
(73) Patentinhaber: Robert Bosch GmbH, 70442 Stuttgart (DE)
(72) Erfinder: BUCK, Thomas, 71732 Tamm (DE); MERZ, Andreas, 71691 Freiberg Am Neckar (DE); KRAYL, Oliver, 70839 Gerlingen (DE); LEIDICH, Stefan, 71277 Rutesheim (DE)
(86) Internationale Anmeldenummer: PCT/EP2017/064304
(87) Internationale Veröffentlichungsnummer: WO 2018/001711

(56) Entgegenhaltungen:
- EP-A1- 1 422 492
- EP-A2- 2 570 776
- DE-A1-102008 012 922

## Beschreibung

Die Erfindung geht aus von einer Spulenanordnung nach der Gattung des unabhängigen Patentanspruchs 1 und von einer Messanordnung mit einer solchen Spulenanordnung nach der Gattung des unabhängigen Patentanspruchs 13.

Aus dem Stand der Technik sind verschiedene Messanordnungen zum Bestimmen einer Induktivität einer oder mehrerer Sensorspulen einer Messspulenanordnung eines Wirbelstromsensors mittels eines Schwingkreises bekannt. Anhand der Induktivitäten einzelner Spulen lässt sich einfach auf den gemessenen Drehwinkel schließen. In der Regel erfolgt die Bestimmung einer Induktivität durch die Messung und Integrierung einer Schwingfrequenz einer LC-Oszillatorschaltung, wobei die Schwingfrequenz von der Induktivität abhängig ist. Die Messung der Frequenz des LC-Oszillators kann mit sehr geringem Aufwand in einem ASIC oder Mikrocontroller realisiert werden. Entsprechend kann die erfasste Schwingfrequenz auch von einer von außen induzierten Spannung beeinflusst werden, sodass die Schwingfrequenz nicht mehr nur von der LC-Resonanzbedingung abhängig ist, sondern auch von der Frequenz des externen, die Spannung induzierenden Störsignals. Durch Aufteilen der Sensorspulen in zwei Teile und einer Invertierung des Wicklungssinns kann diese Einkopplung reduziert werden. Durch diese Maßnahme wird jedoch in der Regel auch die Induktivität reduziert, die jedoch maßgeblich die Spulengüte und somit die Frequenzstabilität bestimmt.

Eine reale Spulenanordnung ist nie vollständig planar und weist mehrere Bereiche auf, in denen externe Felder Spannungen induzieren können. So können bei ein- oder zweilagigen Spulen signifikante Empfindlichkeiten gegenüber magnetischen Störfeldern gegeben sein, wenn es ein nicht kompensiertes Störfeld innerhalb der Spulenanordnung gibt, welches in der Regel durch die Struktur der Durchkontaktierungen in einer mehrlagigen Leiterplatte verursacht wird. Die Durchkontaktierungen werden verwendet, um die Spule mit einer Auswerteschaltung zu kontaktieren. Erhebliche Signaleinkopplungen durch elektrische Felder können auftreten, wenn die Spulenanordnung an beiden Anschlüssen nicht die gleiche Impedanz aufweist und wenn hinter der Spulenanordnung eine geerdete Fläche angeordnet ist.

Es gibt auch Ansätze die Empfindlichkeit gegenüber homogenen externen Feldern in die Hauptmessrichtung zu reduzieren, welche auf der Idee basieren, dass der Wirbelstrom eine lokale Wirkung des Nahfelds ist, während das Störfeld als homogenes Fernfeld betrachtet werden kann. Aus der DE 10 2008 012 922 A1 ist beispielsweise ein induktiver planar aufgebauter Winkelsensor mit einem Stator, welcher einer mindestens ein Erregerelement und mindestens ein Empfangselement umfasst, einem Rotor und einer Auswerteschaltung bekannt. Das Erregerelement ist als Spule mit einer ersten äußeren Wicklung und einer darin beabstandet angeordneten gegenläufigen zweiten Wicklung ausgebildet. Damit weist das Erregerelement zwei Spulen auf, welche bei Anliegen einer Spannung entgegengesetzte elektromagnetische Felder erzeugen. Je nach Anforderung an die Feldstärke können mehrere parallele Wicklungen in unterschiedlichen Lagen einer Leiterplatte angeordnet werden, wobei die Enden der Wicklungen über eine Durchkontaktierung elektrisch miteinander verbunden sind.

Aus der EP 1 422 41021 A2 ist eine gattungsgemäße Spulenanordnung mit einer Spulenwicklung und einer mehrlagigen Leiterplatte bekannt. Die Spulenwicklung weist mehrere Schleifen auf, welche in verschiedenen Lagen der Leiterplatte angeordnet sind und ein magnetische Hauptfeld mit einer senkrecht zu einer Hauptebene der Leiterplatte stehenden Hauptrichtung ausbilden. Die in verschiedenen Lagen angeordneten Schleifen sind über mindestens eine Durchkontaktierung elektrisch miteinander verbunden, wobei die Leiterplatte ein ganzzahliges Vielfaches von vier Durchkontaktierungen aufweist, welche zwischen den Schleifen der Spulenwicklung eine gleiche Anzahl von Abwärtsstrompfaden und Aufwärtsstrompfaden ausbilden.

Die Spulenanordnung mit den Merkmalen des unabhängigen Patentanspruchs 1 und die Messanordnung mit den Merkmalen des abhängigen Patentanspruchs 13 haben den Vorteil, dass Kopplungseffekte von externen magnetischen Störquellen zumindest reduziert und im Idealfall vollständig vermieden werden können. Aufgrund der paarweisen Punktsymmetrie der Durchkontaktierungen werden alle Störfelder in den Nebenebenen in entgegengesetzter Richtung ausgerichtet und kompensieren sich so gegenseitig. Dies gilt sowohl in den beiden zur Hauptrichtung orthogonalen Richtungen und aufgrund des Überlagerungsprinzips auch für jede andere Richtung in der Hauptebene.

Ausführungsformen der Erfindung können beispielsweise für Winkel- oder Linearsensoren mit mehrlagigen Leiterplatten eingesetzt werden. Theoretisch kann die Konstruktion vollständig immun gegen alle homogenen Magnetfelder, welche in senkrecht zur Hauptebene angeordneten Nebenebenen erzeugt werden, und gegen außerhalb der Hauptebene aufgebaute elektrische Felder ausgeführt werden. Dies schließt die tatsächliche Erfassungsrichtung bzw. Hauptrichtung aus, wo die Einkopplung zur Umsetzung des Messprinzips stattfindet.

Ausführungsformen der vorliegenden Erfindung stellen eine Spulenanordnung mit einer Spulenwicklung und einer mehrlagigen Leiterplatte zur Verfügung. Die Spulenwicklung weist mehrere Schleifen auf, welche in verschiedenen Lagen der Leiterplatte angeordnet sind und ein magnetische Hauptfeld mit einer senkrecht zu einer Hauptebene der Leiterplatte stehenden Hauptmessrichtung ausbilden. Die in verschiedenen Lagen angeordneten Schleifen sind über mindestens eine Durchkontaktierung elektrisch miteinander verbunden. Zur Kompensation von magnetischen Störfeldern weist die Leiterplatte mindestens vier Durchkontaktierungen oder ein ganzzahliges Vielfaches von vier Durchkontaktierungen auf, welche zwischen den Schleifen der Spulenwicklung eine gleiche Anzahl von Abwärtsstrompfaden und Aufwärtsstrompfaden ausbilden. Jeweils zwei Durchkontaktierungen mit gleicher Strompfadrichtung sind punktsymmetrisch zu einem gemeinsamen Spiegelpunkt angeordnet, so dass magnetische Störfelder, welche sich in senkrecht zur Hauptebene angeordneten Nebenebenen der Leiterplatte ausbilden, entgegengesetzte Richtungen aufweisen und sich gegenseitig kompensieren.

Zudem wird eine Messanordnung mit einem Verstärker und einem Schwingkreis vorgeschlagen, welcher mindestens eine Kapazität und eine Messspulenanordnung umfasst, welche als erfindungsgemäße Spulenanordnung ausgeführt ist. Hierbei repräsentiert ein Ausgabesignal des Verstärkers als Messsignal eine Induktivität und/oder Induktivitätsänderung der Messspulenanordnung.

Durch die in den abhängigen Ansprüchen aufgeführten Maßnahmen und Weiterbildungen sind vorteilhafte Verbesserungen der im unabhängigen Patentanspruch 1 angegebenen Spulenanordnung und der im unabhängigen Patentanspruch 1, angegebenen Messanordnung mit einer solchen Spulenanordnung möglich.

Besonders vorteilhaft ist, dass die mindestens vier Durchkontaktierungen entlang einer gemeinsamen Geraden angeordnet werden können. Zudem können die entlang der gemeinsamen Geraden angeordneten Durchkontaktierungen bei einer besonders vorteilhaften Ausführungsform möglichst kleine Abstände zueinander aufweisen, so dass die Auswirkungen von inhomogenen Störfeldern verringert werden können

Grundsätzlich können die jeweils zwei Durchkontaktierungen mit gleicher Strompfadrichtung an einem beliebigen Punkt gespiegelt werden. In weiterer vorteilhafter Ausgestaltung der Spulenanordnung können die paarweise punktsymmetrisch angeordneten Durchkontaktierungen am Schwerpunkt der Spulenanordnung als Spiegelpunkt gespiegelt werden, welcher durch einen gemeinsamen Schnittpunkt zwischen Verbindungsgeraden der paarweise punktsymmetrisch angeordneten Durchkontaktierungen vorgegeben werden kann. Zudem kann ein Winkel zwischen zwei Verbindungsgeraden einen beliebigen Wert zwischen 0 und 360° aufweisen.

In weiterer vorteilhafter Ausgestaltung der Spulenanordnung kann die Spulenwicklung jeweils eine als Abwärtsstrompfad ausgebildete Durchkontaktierung mit einer als Aufwärtsstrompfad ausgebildeten Durchkontaktierung und eine als Aufwärtsstrompfad ausgebildete Durchkontaktierung mit einer als Abwärtsstrompfad ausgebildeten Durchkontaktierung elektrisch verbinden. Zum Schließen der Spulenwicklung ist für jede als Abwärtsstrompfad ausgebildete Durchkontaktierung eine als Aufwärtsstrompfad ausgebildete Durchkontaktierung vorhanden. Hierbei wird jedes Paar aus einer als Abwärtsstrompfad ausgebildeten ersten Durchkontaktierung und einer als Aufwärtsstrompfad ausgebildeten zweiten Durchkontaktierung durch ein ähnliches Paar aus einer als Abwärtsstrompfad ausgebildeten ersten Durchkontaktierung und einer als Aufwärtsstrompfad ausgebildeten zweiten Durchkontaktierung kompensiert, welches an einem beliebigen Punkt gespiegelt ist. Des Weiteren können zumindest eine erste Schleife, welche in einer ersten Lage der Leiterplatte eine als Abwärtsstrompfad ausgebildete erste Durchkontaktierung mit einer als Aufwärtsstrompfad ausgebildeten zweiten Durchkontaktierung elektrisch verbindet, und zumindest eine zweite Schleife, welche in einer zweiten Lage der Leiterplatte die als Aufwärtsstrompfad ausgebildete zweite Durchkontaktierung mit einer als Abwärtsstrompfad ausgebildeten dritten Durchkontaktierung elektrisch verbindet, und zumindest eine dritte Schleife, welche in der ersten Lage der Leiterplatte die als Abwärtsstrompfad ausgebildete dritte Durchkontaktierung mit einer als Aufwärtsstrompfad ausgebildeten vierten Durchkontaktierung elektrisch verbindet, und zumindest eine vierte Schleife, welche in der zweiten Lage der Leiterplatte die als Aufwärtsstrompfad ausgebildete vierte Durchkontaktierung mit der als Abwärtsstrompfad ausgebildeten ersten Durchkontaktierung elektrisch verbindet, die gleiche Orientierung aufweisen.

In weiterer vorteilhafter Ausgestaltung der Spulenanordnung können die elektrischen Verbindungen zwischen den als Abwärtsstrompfade ausgebildeten Durchkontaktierungen und den als Aufwärtsstrompfade ausgebildeten Durchkontaktierungen und/oder zwischen den als Aufwärtsstrompfade ausgebildeten Durchkontaktierungen und den als Abwärtsstrompfade ausgebildeten Durchkontaktierungen eine beliebige Anzahl von Schleifen aufweisen, wobei die Schleifen keinen Schnittpunkt mit der Verbindungslinie zwischen den als Aufwärtsstrompfade ausgebildeten Durchkontaktierungen aufweisen, um die Topologie zu halten.

In weiterer vorteilhafter Ausgestaltung der Spulenanordnung kann die Leiterplatte ein Anschlussterminal mit vier Anschlusskontaktierungen aufweisen, welche jeweils paarweise punktsymmetrisch zum gemeinsamen Spiegelpunkt angeordnet sind, wobei zwei Anschlusskontaktierungen als Abwärtsstrompfade und zwei Anschlusskontaktierungen als Aufwärtsstrompfade ausgebildet sind. Hierbei können eine als Abwärtsstrompfad ausgeführte erste Anschlusskontaktierung und eine als Aufwärtsstrompfad ausgebildete zweite Anschlusskontaktierung jeweils als Spulenanschlüsse in einer dritten Lage ausgebildet werden, und eine als Abwärtsstrompfad ausgeführte dritte Anschlusskontaktierung und eine als Aufwärtsstrompfad ausgebildete vierte Anschlusskontaktierung können jeweils als Kompensationskontaktierung ausgebildet werden. Die Schleife durch die beiden Kompensationskontaktierungen erzeugt in einem magnetischen Störfeld eine Spannung mit entgegengesetzter Polarität, welche die an den Spulenanschlüssen durch das gleiche magnetische Störfeld induzierte Spannung kompensieren kann. Zudem können die erste Anschlusskontaktierung und die zweite Anschlusskontaktierung in eine erste Verbindung zwischen zwei Durchkontaktierungen eingeschleift werden und diese unterbrechen. Hierbei können die dritte Anschlusskontaktierung und die vierte Anschlusskontaktierung in eine korrespondierende am gemeinsamen Spiegelpunkt gespiegelte Verbindung zwischen zwei Durchkontaktierungen eingeschleift werden und diese unterbrechen, wobei die dritte Anschlusskontaktierung und die vierte Anschlusskontaktierung in der dritten Lage elektrisch miteinander verbunden werden können.

In weiterer vorteilhafter Ausgestaltung der Spulenanordnung kann das Anschlussterminal vier zusätzliche Durchkontaktierungen aufweisen, welche die Anschlusskontaktierungen ausbilden. Um den Entwurf zu vereinfachen und die Anzahl von Durchkontaktierungen zu verringern kann das Anschlussterminal alternativ nur zwei zusätzliche Durchkontaktierungen aufweisen, wobei eine zusätzliche Durchkontaktierung und eine Durchkontaktierung der Spulenwicklung jeweils eine Anschlusskontaktierung ausbilden können, und eine zusätzliche Durchkontaktierung und eine Durchkontaktierung der Spulenwicklung jeweils eine Kompensationskontaktierung ausbilden können.

In vorteilhafter Ausgestaltung der Messanordnung kann der Schwingkreis als Pi-LC-Netzwerk mit zwei Kapazitäten ausgeführt werden, zwischen welchen die Messspulenanordnung angeordnet werden kann. Dies ermöglicht eine einfache und kostengünstige Implementierung, da entsprechende Schaltkreise als Massenprodukte zur Verfügung stehen.

In weiterer vorteilhafter Ausgestaltung der Messanordnung kann der Verstärker als einfacher logischer Inverter ausgeführt werden, dessen Eingang mit einer ersten Seite des Schwingkreises verbunden werden kann und dessen invertierender Ausgang das Messsignal ausgibt, welches über einen ohmschen Widerstand an eine zweite Seite des Schwingkreises rückgekoppelt werden kann.

Alternativ kann der Verstärker als Differenzverstärker ausgeführt werden, dessen invertierender Eingang mit einer ersten Seite des Schwingkreises und dessen nicht invertierender Eingang mit einer zweiten Seite des Schwingkreises (SK2) verbunden werden kann, wobei ein invertierender Ausgang über einen ersten ohmschen Widerstand mit der ersten Seite des Schwingreises rückgekoppelt werden, und ein nichtinvertierender Ausgang das Messsignal ausgeben kann, welches über einen zweiten ohmschen Widerstand an die zweite Seite des Schwingkreises rückgekoppelt werden kann. Bei dieser symmetrischen Oszillatorschaltung erfasst der Differenzverstärker an beiden Anschlüssen der Spulenanordnung die typischerweise ähnlich induzierten Störsignale und koppelt ein Gleichtaktsignal an die Differenzverstärkereingänge zurück, so dass die Störsignale im Idealfall keinen Einfluss auf das Ausgabesignal haben. Es kann gezeigt werden, dass die effektive Wirkung "Null" ist, wenn die induzierten Störsignale die gleiche Amplitude und Phase aufweisen. Dadurch wird die Messanordnung auch immun gegen elektrische Felder.

Ausführungsformen der vorliegenden Erfindung und die beschriebene Art der Kompensation von magnetischen Störfeldern kann mit dem in DE 10 2008 012 922 A1 beschriebenen Ansatz kombiniert werden, welcher die Wirkung von Störfeldern außerhalb der Hauptmessebene reduziert.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt ein schematisches Schaltbild eines ersten Ausführungsbeispiels einer Messanordnung mit einer erfindungsgemäßen Spulenanordnung.
Fig. 2 zeigt ein schematisches Schaltbild der Messanordnung aus Fig. 1 mit induzierten Störspannungen.
Fig. 3 zeigt eine schematische Darstellung eines ersten Ausführungsbeispiels einer Leiterplatte für die Spulenanordnung aus Fig. 1 und 2.
Fig. 4 zeigt eine schematische Darstellung eines Ausführungsbeispiels einer ersten Lage der Leiterplatte aus Fig. 3.
Fig. 5 zeigt eine schematische Darstellung eines Ausführungsbeispiels einer zweiten Lage der Leiterplatte aus Fig. 3.
Fig. 6 zeigt eine schematische transparente Darstellung der Leiterplatte aus Fig. 3 mit den in Fig. 4 und 5 dargestellten Leiterplattenlagen.
Fig. 7 zeigt eine schematische Darstellung eines zweiten Ausführungsbeispiels einer Leiterplatte für die Spulenanordnung aus Fig. 1 und 2 mit einem ersten Ausführungsbeispiel eines Anschlussterminals.
Fig. 8 zeigt eine schematische Darstellung eines dritten Ausführungsbeispiels einer Leiterplatte für die Spulenanordnung aus Fig. 1 und 2 mit einem zweiten Ausführungsbeispiel eines Anschlussterminals.
Fig.9 zeigt ein schematisches Schaltbild eines zweiten Ausführungsbeispiels einer Messanordnung mit einer erfindungsgemäßen Spulenanordnung.
Fig. 10 zeigt ein schematisches Schaltbild der Messanordnung aus Fig. 9 mit induzierten Störspannungen.
Fig. 11 zeigt eine schematische Darstellung einer symmetrischen, bezogen auf elektrische Felder vollständig kompensierten Spulenanordnung.
Fig. 12 zeigt eine schematische Darstellung der abgerollten in Fig. 11 dargestellten Spulenanordnung.
Fig. 13 zeigt eine schematische Darstellung einer nicht symmetrischen Spulenanordnung.
Fig. 14 zeigt eine schematische Darstellung der abgerollten in Fig. 13 dargestellten Spulenanordnung.

### Ausführungsformen der Erfindung

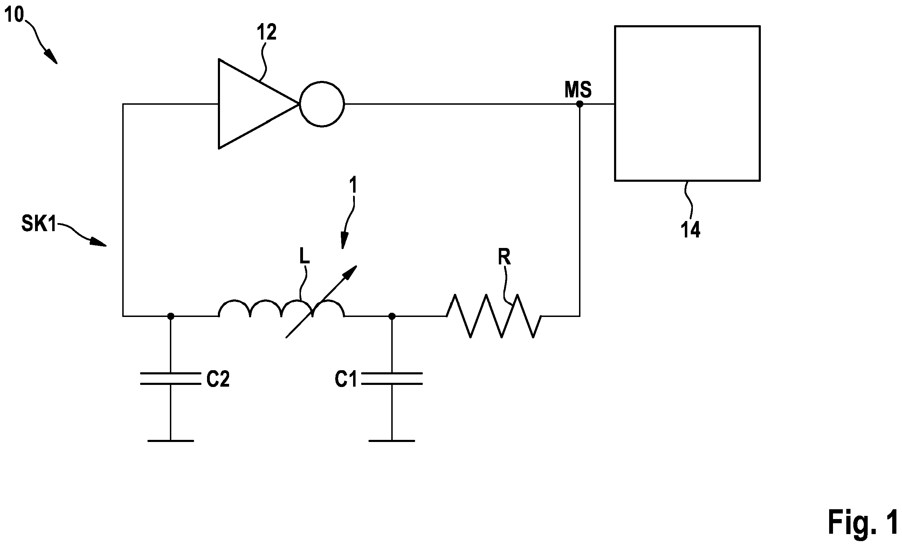

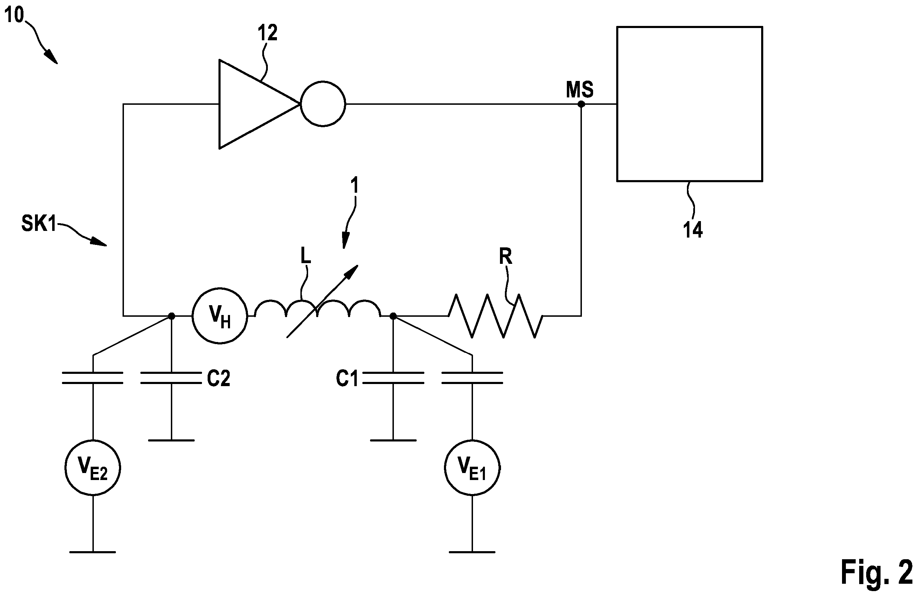

Wie aus Fig. 1 und 2 ersichtlich ist, umfasst das dargestellte erste Ausführungsbeispiel einer erfindungsgemäßen Messanordnung 10 einen invertierenden Verstärker 12 und einen Schwingkreis SK1, welcher mindestens eine Kapazität C1, C2 und eine Messspulenanordnung L umfasst. Ein Ausgabesignal des Verstärkers 12 repräsentiert als Messsignal MS eine Induktivität und/oder Induktivitätsänderung der Messspulenanordnung L. Im dargestellten Ausführungsbeispiel ist der Schwingkreis SK1 als Pi-LC-Netzwerk mit zwei Kapazitäten C1, C2 ausgeführt, zwischen welchen die Messspulenanordnung L angeordnet ist. Der Verstärker 12 ist als Inverter ausgeführt, dessen Eingang mit einer ersten Seite des Schwingkreises SK1 verbunden ist und dessen invertierender Ausgang das Messsignal MS ausgibt, welches über einen ohmschen Widerstand R an eine zweite Seite des Schwingkreises SK1 rückgekoppelt ist.

Fig. 2 zeigt die induzierten Störspannungen V_{H}, V_{E1}, V_{E2} im Schaltbild der Messanordnung 10. Um eine Verschiebung der Eigenfrequenz des LC-Schwingkreises SK1 durch magnetische und elektrische Störfelder zu vermeiden oder zu reduzieren, wird eine von einem magnetischen Feld induzierte Störspannung V_{H} nahezu auf "Null" reduziert, weil es schwierig ist, die sich aus magnetischen Störfeldern ergebende Störspannung V_{H} auf andere Art zu kompensieren. Dies gilt nicht für die Störspannungen V_{E1}, V_{E2}, welche von elektrischen Störfeldern verursacht werden. Theoretisch sind die beiden von elektrischen Störfeldern verursachten Störspannungen V_{E1}, V_{E2} in Phase und verschieben den linken und den rechten Anschluss der Messspulenanordnung L in ähnlicher Weise. Trotzdem kann die Wirkung der von elektrischen Störfeldern induzierten Störspannungen V_{E1}, V_{E2} dramatisch sein, wenn der Schwingkreis SK1 in Bezug auf die Impedanzen, welche an beiden Seiten der Messspulenanordnung L gesehen werden, nicht symmetrisch ist. Im dargestellten Ausführungsbeispiel misst ein Zähler 14 eine Frequenz des Messsignals MS.

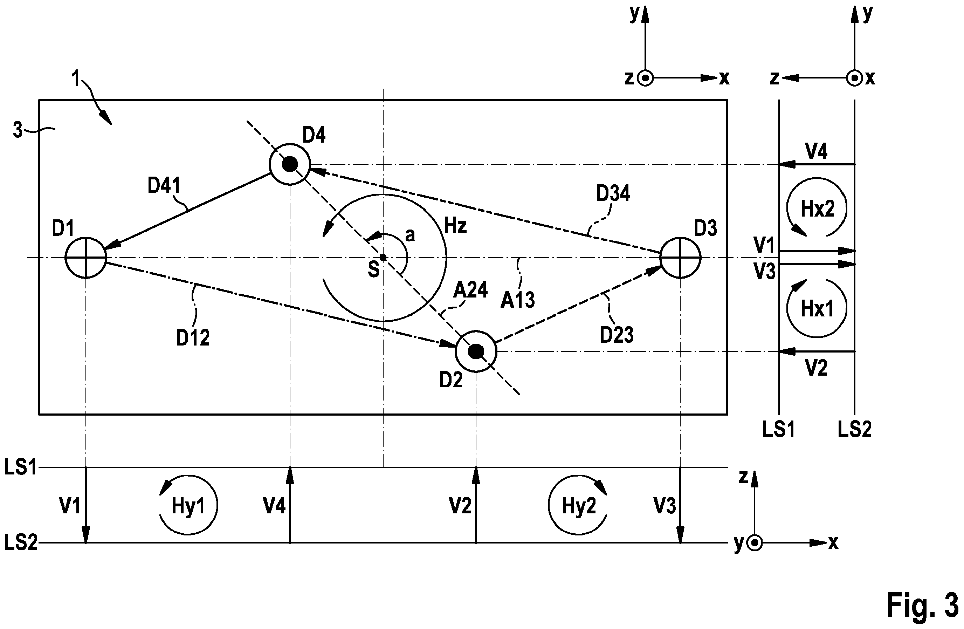

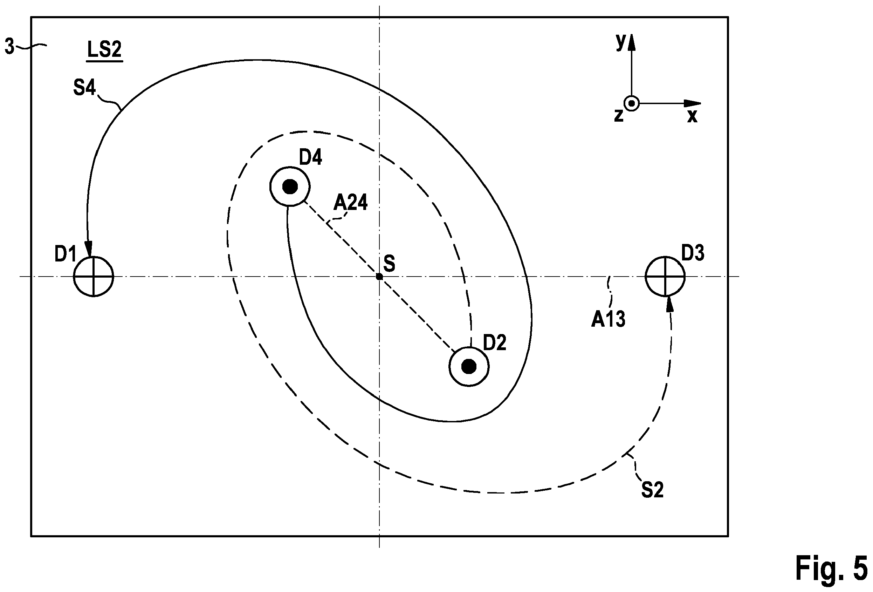

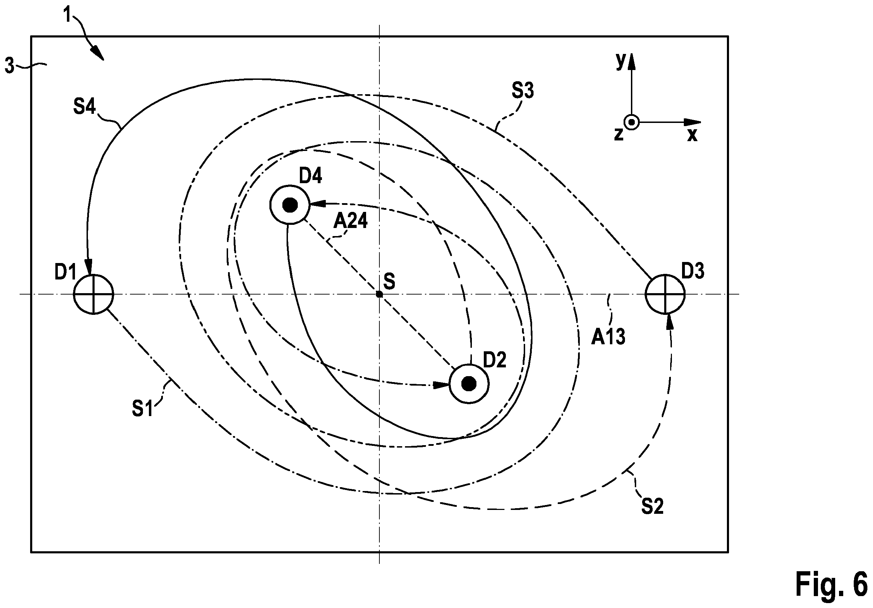

Wie aus Fig. 3 bis 8 ersichtlich ist, umfasst eine erfindungsgemäße Spulenanordnung 1, 1A, 1B, welche als Messspulenanordnung L in der Messanordnung 10 eingesetzt werden kann, eine Spulenwicklung und eine mehrlagige Leiterplatte 3. Die Spulenwicklung weist mehrere Schleifen S1, S2, S3, S4 auf, welche in verschiedenen Lagen LS1, LS2 der Leiterplatte 3 angeordnet sind und ein magnetische Hauptfeld Hz mit einer senkrecht zu einer Hauptebene (x-y) der Leiterplatte 3 stehenden Hauptmessrichtung z ausbilden. Die in verschiedenen Lagen LS1, LS2 angeordneten Schleifen S1, S2, S3, S4 sind über mindestens eine Durchkontaktierung D1, D2, D3, D4 elektrisch miteinander verbunden. Hierbei weist die Leiterplatte 3 mindestens vier Durchkontaktierungen D1, D2, D3, D4 oder ein ganzzahliges Vielfaches von vier Durchkontaktierungen D1, D2, D3, D4 auf, welche zwischen den Schleifen S1, S2, S3, S4 der Spulenwicklung eine gleiche Anzahl von Abwärtsstrompfaden V1, V3 und Aufwärtsstrompfaden V2, V4 ausbilden. Ein beliebiges magnetisches Störfeld senkrecht zur z-Achse induziert in den durch die Durchkontaktierungen gebildeten Schleifen Hx1, Hx2, Hy1, Hy2 jeweils eine Spannung. Je nach Orientierung der Schleifen Hx1, Hx2, Hy1, Hy2, bezogen auf eine festgelegte Normal-Stromrichtung durch die Gesamtspule, welche der Pfeilrichtung der elektrischen Verbindungen D12, D23, D34, D41 entspricht, wirken diese Spannungen entweder additiv oder subtraktiv auf die Gesamtspulenspannung. Parallele Schleifen Hx1, Hx2 sowie Hy1, Hy2 in gleichen Ebenen (y-z), (x-z) aber mit gegenläufigem Drehsinn kompensieren sich vollständig. Geometrisch sind jeweils zwei Durchkontaktierungen D1, D3; D2, D4 mit gleicher Strompfadrichtung punktsymmetrisch zueinander angeordnet, so dass magnetische Schleifen Hy1, Hy2, Hx1, Hx2, welche sich in senkrecht zur Hauptebene (x-y) angeordneten Nebenebenen (x-z), (y-z) der Leiterplatte 3 ausbilden, entgegengesetzte Richtungen aufweisen und sich gegenseitig kompensieren.

Wie aus Fig. 3 bis 6 weiter ersichtlich ist, weist die Spulenanordnung 1 im dargestellten Ausführungsbeispiel vier Durchkontaktierungen D1, D2, D3, D4 auf. Fig. 3 zeigt die Hauptebene (x-y) der Leiterplatte 3 mit dem magnetischen Hauptfeld Hz von oben und eine Projektion auf die beiden senkrecht zur Hauptebene (x-y) verlaufenden Nebenebenen (x-z), (y-z) zusammen mit den resultierenden magnetischen Schleifen Hy1, Hy2, Hx1, Hx2 in diesen Nebenebenen (x-z), (y-z) und ihre Orientierung.

Wie aus Fig. 3 ersichtlich ist, sind die Durchkontaktierungen D1, D2, D3, D4 in Abhängigkeit von der vorgegebenen Strompfadrichtungen durch nach oben oder unten verlaufende Vektoren dargestellt, welche die Abwärtsstrompfade V1, V3 oder die Aufwärtsstrompfade V2, V4 repräsentieren. Die Projektionen in die Nebenebenen (x-z), (y-z) zeigen die Vektoren und die daraus resultierenden Orientierungen der entsprechenden magnetischen Schleifen Hy1, Hy2, Hx1, Hx2. Aufgrund der paarweisen Punktsymmetrie der Durchkontaktierungen D1, D2, D3, D4 sind die magnetischen Schleifen Hy1, Hy2, Hx1, Hx2 in einer Nebenebene (x-z), (y-z) in entgegengesetzter Richtung ausgerichtet und kompensieren sich so gegenseitig. Dies gilt sowohl in den beiden zur Hauptrichtung z orthogonalen Richtungen x, y und aufgrund des Überlagerungsprinzip so auch für jede andere Richtung in der Hauptebene (x-y). Das bedeutet, dass sich im dargestellten Ausführungsbeispiel jeweils die beiden magnetischen Schleifen Hy1, Hy2 in der (x-z)-Nebenebene und die beiden magnetischen Schleifen Hx1, Hx2 in der (y-z)-Nebenebene gegenseitig kompensieren. Dadurch kann die sich aus magnetischen Störfeldern ergebende Störspannung V_{H} in der Messanordnung 10 in vorteilhafter Weise nahezu auf "Null" reduziert werden.

Zum Schließen der Spulenwicklung ist für jede als Abwärtsstrompfade V1, V3 ausgebildete Durchkontaktierung D1, D3 eine als Aufwärtsstrompfade V2, V4 ausgebildete Durchkontaktierung D2, D4 vorhanden. Hierbei wird jedes Paar aus einer als Abwärtsstrompfad V1 ausgebildeten ersten Durchkontaktierung D1 und einer als Aufwärtsstrompfad V2 ausgebildeten zweiten Durchkontaktierung D2 durch ein ähnliches Paar aus einer als Abwärtsstrompfad V3 ausgebildeten dritten Durchkontaktierung D3 und einer als Aufwärtsstrompfad V4 ausgebildeten vierten Durchkontaktierung D4 kompensiert, welches an einem beliebigen Spiegelpunkt S gespiegelt ist. Bei einer besonders vorteilhaften Ausführungsform sind die Durchkontaktierungen entlang einer gemeinsamen Gerade angeordnet und weisen möglichst kleine Abstände zueinander, so dass die Auswirkungen von inhomogenen Störfeldern verringert werden können.

Wie aus Fig. 3 weiter ersichtlich ist, werden die paarweise punktsymmetrisch angeordneten Durchkontaktierungen D1, D3; D2, D4 am Schwerpunkt der Spulenanordnung 1 als Spiegelpunkt S gespiegelt, welcher durch einen gemeinsamen Schnittpunkt zwischen Verbindungsgeraden A13, A24 der paarweise punktsymmetrisch angeordneten Durchkontaktierungen D1, D3; D2, D4 vorgegeben ist. Ein Winkel a zwischen zwei Verbindungsgeraden A13, A24 kann einen beliebigen Wert zwischen 0 und 360° aufweisen.

Durch den punktsymmetrischen Ansatz mit mindestens vier Durchkontaktierungen D1, D2, D3, D4 oder einem ganzzahligen Vielfachen von vier Durchkontaktierungen D1, D2, D3, D4 (n*(4*Durchkontaktierungen) mit (n> = 1)) sind die Kompensationskriterien erfüllt.

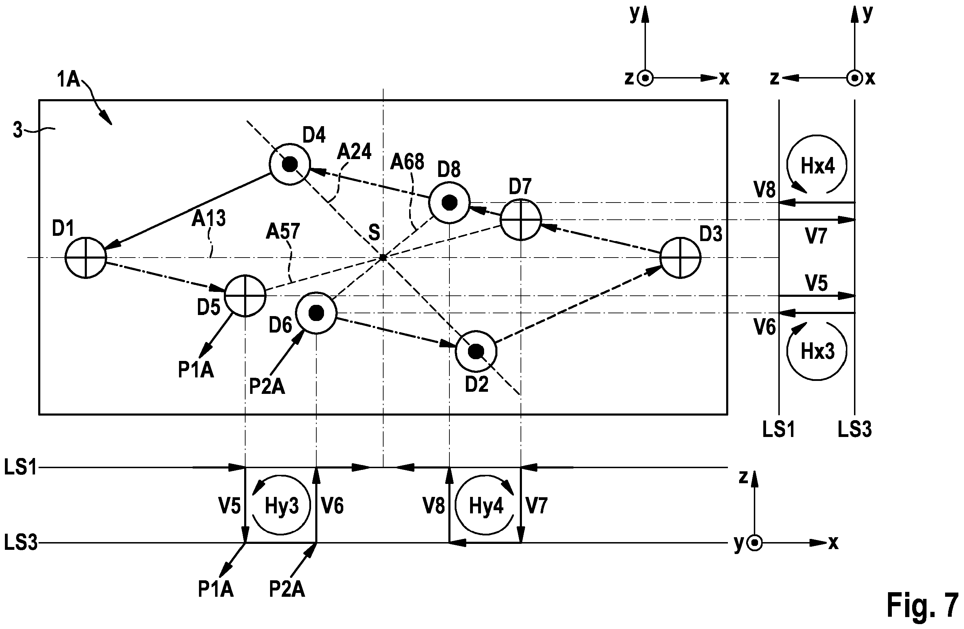

Die Schleifen S1, S2, S3, S4 der Spulenwicklung auf den verwendeten Lagen LS1, LS2 der Leiterplatte 3 verbinden elektrisch jeweils eine als Abwärtsstrompfad V1, V3 ausgebildete Durchkontaktierung D1, D3 mit einer als Aufwärtsstrompfad V2, V4 ausgebildeten Durchkontaktierung D2, D4 und eine als Aufwärtsstrompfad V2, V4 ausgebildete Durchkontaktierung D2, D4 mit einer als Abwärtsstrompfad V1, V3 ausgebildeten Durchkontaktierung D1, D3. In Fig. 3 sind die elektrischen Verbindungen D12, D23, D34, D41 vereinfacht als Pfeile dargestellt, wobei eine erste und dritte elektrische Verbindung D12, D34 in einer ersten Lage LS1 der Leiterplatte 3 angeordnet sind, und eine zweite und vierte elektrische Verbindung D23, D41 in einer zweiten Lage LS2 der Leiterplatte 3 angeordnet sind. Die Spulenwicklung kann zur Kontaktierung an einer beliebigen der elektrischen Verbindungen D12, D23, D34, D41 unterbrochen werden, wie nachfolgend unter Bezugnahme auf Fig. 7 bis 14 beschrieben wird. Wie später gezeigt wird, gibt es Vorteile für die Kontaktierung, wenn eine elektrische Verbindung D12, D23, D34, D41 in der Mitte geschnitten wird.

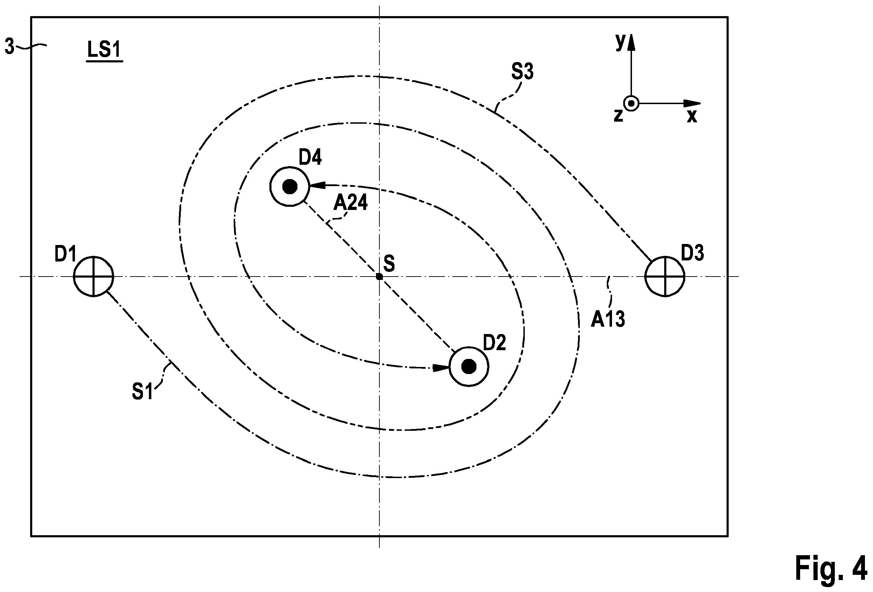

Wie aus Fig. 4 bis 6 weiter ersichtlich ist, kann die erste oder zweite Lage LS1, LS2 der Leiterplatte 3 um den Spiegelpunkt S gedreht werden, um die tatsächlichen Schleifen S1, S2, S3, S4 der Spulenwicklung und damit die elektrischen Verbindungen D12, D23, D34, D41 innerhalb der ersten und zweiten Lage LS1, LS2 zu konstruieren. Fig. 4 zeigt die beiden in der ersten Lage LS1 der Leiterplatte 3 ausgebildete Schleifen S1, S3. Hierbei verbindet eine erste Schleife S1 die erste Durchkontaktierung D1 mit der zweiten Durchkontaktierung D2 und eine dritte Schleife S3 verbindet die dritte Durchkontaktierung D3 mit der vierten Durchkontaktierung D4. Fig. 4 zeigt die beiden in der zweiten Lage LS2 der Leiterplatte 3 ausgebildete Schleifen S2, S4. Hierbei verbindet eine zweite Schleife S2 die zweite Durchkontaktierung D2 mit der dritten Durchkontaktierung D3 und eine vierte Schleife S4 verbindet die vierte Durchkontaktierung D4 mit der ersten Durchkontaktierung D1. Die Schleifen S1, S2, S3, S4 in den beiden Lagen LS1, LS2 der Leiterplatte 3 weisen die gleiche Orientierung auf und können mit beliebig vielen Windungen ausgeführt werden. Um die Topologie zu halten, weisen die Schleifen S1, S2, S3, S4 keinen Schnittpunkt mit der Verbindungslinie A24 zwischen den als Aufwärtsstrompfade V2, V3 ausgebildeten Durchkontaktierungen D2, D4 auf, sondern nur Schnittpunkte mit der Verbindungslinie A213 zwischen den als Abwärtsstrompfade V1, V3 ausgebildeten Durchkontaktierungen D1, D3 auf.

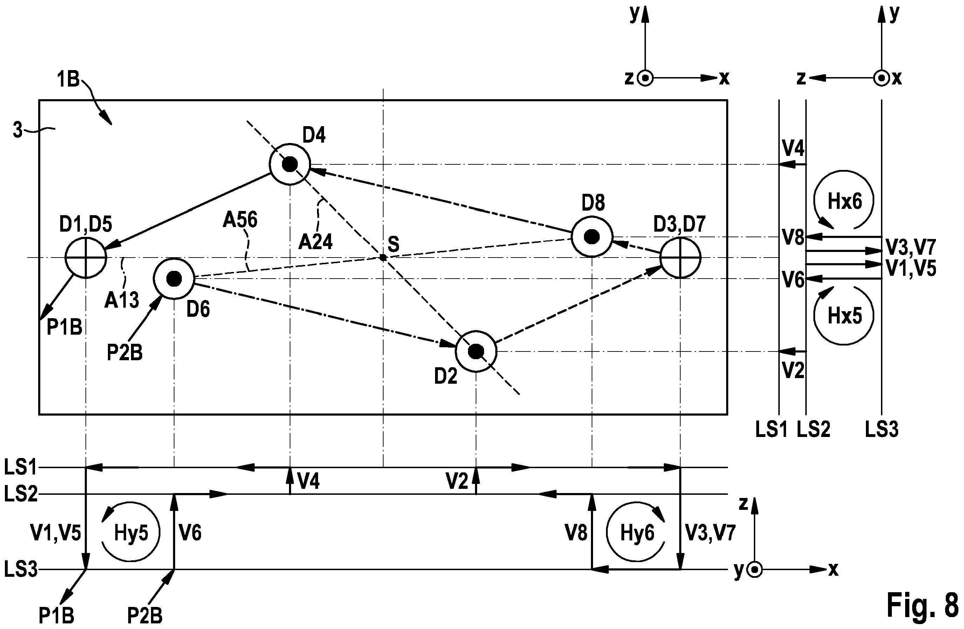

Wie oben bereits angedeutet wurden, können die Spulenanschlüsse an einer beliebigen Stelle in der Spulenwicklung angeordnet werden. Wie aus Fig. 7 und 8 ersichtlich ist, weist die Leiterplatte 3 für die Kontaktierung der Spulenwicklung ein Anschlussterminal mit mindestens zwei Anschlusskontaktierungen D5, D6, D7, D8 auf. Diese Anschlusskontaktierungen D5, D6, D7, D8 erzeugen unmittelbar weitere magnetische Schleifen Hy3, Hx3, welche durch in entgegengesetzter Richtung ausgerichtete weitere Schleifen Hy4, Hx4 kompensiert werden.

Wie aus Fig. 7 weiter ersichtlich ist, weist die Leiterplatte 3 im dargestellten ersten Ausführungsbeispiel der Spulenanordnung 1A ein Anschlussterminal mit vier Anschlusskontaktierungen D5, D6, D7, D8 auf, welche jeweils paarweise punktsymmetrisch zum gemeinsamen Spiegelpunkt S angeordnet sind. Die Anschlusskontaktierungen D5, D6, D7, D8 des dargestellten Anschlussterminals werden durch vier zusätzliche in die Leiterplatte 3 eingebrachte Durchkontaktierungen ausgebildet. Hierbei sind zwei Anschlusskontaktierungen D5, D7 als Abwärtsstrompfade V5, V7 und zwei Anschlusskontaktierungen D6, D8 als Aufwärtsstrompfade V6, V8 ausgebildet. Wie aus Fig. 7 weiter ersichtlich ist, sind eine als Abwärtsstrompfad V5 ausgeführte erste Anschlusskontaktierung D5 und eine als Aufwärtsstrompfad V6 ausgebildete zweite Anschlusskontaktierung D6 jeweils als Spulenanschlüsse P1A, P2A in einer dritten Lage LS3 ausgebildet und in der ersten Lage LS2 in die erste elektrische Verbindung D12 zwischen der ersten Durchkontaktierung D1 und der zweiten Durchkontaktierung D2 eingeschleift. Das bedeutet, dass die erste Durchkontaktierung D1 in der ersten Lage LS1 elektrisch mit der ersten Anschlusskontaktierung D5, und die zweite Anschlusskontaktierung D6 in der ersten Lage LS1 elektrisch mit der zweiten Durchkontaktierung D2 verbunden ist. Eine als Abwärtsstrompfad V7 ausgeführte dritte Anschlusskontaktierung D7 und eine als Aufwärtsstrompfad V8 ausgebildete vierte Anschlusskontaktierung D8 sind jeweils als Kompensationskontaktierungen ausgebildet und in der ersten Lage LS1 in die korrespondierende am gemeinsamen Spiegelpunkt S gespiegelte dritte elektrische Verbindung D34 zwischen der dritten Durchkontaktierung D3 und der vierten Durchkontaktierung D4 eingeschleift, so dass magnetische Schleifen Hy3, Hy4, Hx3, Hx4, welche sich in senkrecht zur Hauptebene (x-y) angeordneten Nebenebenen (x-z), (y-z) der Leiterplatte 3 ausbilden, entgegengesetzte Richtungen aufweisen und sich gegenseitig kompensieren. Die dritte Anschlusskontaktierung D7 und die vierte Anschlusskontaktierung D8 unterbrechen die erste elektrische Verbindung D13 in der ersten Lage LS1 und sind in der dritten Lage LS3 elektrisch miteinander verbunden. Das bedeutet, dass die dritte Durchkontaktierung D3 in der ersten Lage LS1 elektrisch mit der dritten Anschlusskontaktierung D7, und die vierte Anschlusskontaktierung D8 in der ersten Lage LS1 elektrisch mit der vierten Durchkontaktierung D4 verbunden ist.

Um den Entwurf zu vereinfachen und die Anzahl von Durchkontaktierungen in der Leiterplatte 3 zu verringern, können Durchkontaktierungen D1, D2, D3, D4 der Spulenwicklung auch als Anschlusskontaktierungen D5, D6, D7, D8 eingesetzt werden, wie aus Fig. 8 ersichtlich ist.

Wie aus Fig. 8 weiter ersichtlich ist, weist die Leiterplatte 3 im dargestellten zweiten Ausführungsbeispiel der Spulenanordnung 1B analog zum ersten Ausführungsbeispiel ein Anschlussterminal mit vier Anschlusskontaktierungen D5, D6, D7, D8 auf, welche jeweils paarweise punktsymmetrisch zum gemeinsamen Spiegelpunkt S angeordnet sind. Die Anschlusskontaktierungen D5, D6, D7, D8 des dargestellten Anschlussterminals werden durch zwei zusätzliche in die Leiterplatte 3 eingebrachte Durchkontaktierungen und durch zwei bereits vorhandene Durchkontaktierungen D1, D3 der Spulenwicklung ausgebildet. Somit bilden eine zusätzliche erste Durchkontaktierung und die erste Durchkontaktierung D1 der Spulenwicklung jeweils eine Anschlusskontaktierung D5, D8 aus, und eine zweite zusätzliche Durchkontaktierung und die dritte Durchkontaktierung D3 der Spulenwicklung bilden jeweils eine Kompensationskontaktierung D7, D8 aus. Analog zum ersten Ausführungsbeispiel sind zwei Anschlusskontaktierungen D5, D7 als Abwärtsstrompfade V5, V7 und zwei Anschlusskontaktierungen D6, D8 als Aufwärtsstrompfade V6, V8 ausgebildet. Wie aus Fig. 8 weiter ersichtlich ist, bildet die als Abwärtsstrompfad V5 ausgeführte erste Durchkontaktierung D1 gleichzeitig die erste Anschlusskontaktierung D5 und in einer dritten Lage LS3 der Leiterplatte 4 einen ersten Spulenanschluss P1B aus. In der ersten Lage ist die erste Durchkontaktierung D1 bzw. erste Anschlusskontaktierung D5 mit der vierten Durchkontaktierung D4 elektrisch verbunden. Eine als Aufwärtsstrompfad V6 ausgebildete zweite Anschlusskontaktierung D6 ist in der zweiten Lage LS2 in die erste elektrische Verbindung D12 zwischen der ersten Durchkontaktierung D1 und der zweiten Durchkontaktierung D2 eingeschleift und bildet in der dritten Lage LS3 einen zweiten Spulenanschluss P2B aus. In der zweiten Lage LS2 ist die zweite Anschlusskontaktierung D6 mit der zweiten Durchkontaktierung D2 verbunden. Wie aus Fig. 8 weiter ersichtlich ist, bildet die als Abwärtsstrompfad V7 ausgeführte dritte Durchkontaktierung D3 gleichzeitig die dritte Anschlusskontaktierung D7 und in der dritten Lage LS3 der Leiterplatte 4 eine erste Kompensationskontaktierung aus. Eine als Aufwärtsstrompfad V8 ausgebildete vierte Anschlusskontaktierung D8 ist in der zweiten Lage LS2 in die dritte elektrische Verbindung D34 zwischen der dritten Durchkontaktierung D3 und der vierten Durchkontaktierung D4 eingeschleift und bildet in der dritten Lage LS3 eine zweite Kompensationskontaktierung aus. Die dritte Anschlusskontaktierung D7 und die vierte Anschlusskontaktierung D8 sind in der dritten Lage LS3 elektrisch miteinander verbunden. In der zweiten Lage LS2 ist die vierte Anschlusskontaktierung D8 mit der vierten Durchkontaktierung D4 verbunden. In der ersten Lage LS1 ist die zweite Durchkontaktierung D1 mit der dritten Durchkontaktierung D3 bzw. dritten Anschlusskontaktierung D7 verbunden. Dadurch weisen magnetische Schleifen Hy3, Hy4, Hx3, Hx4, welche sich in senkrecht zur Hauptebene (x-y) angeordneten Nebenebenen (x-z), (y-z) der Leiterplatte 3 ausbilden, entgegengesetzte Richtungen auf und kompensieren sich gegenseitig. Durch kombinierte Nutzung von Durchkontaktierungen wird die Anzahl von Durchkontaktierungen auf Kosten der vollständigen Symmetrie zur Kompensation von elektrischen Feldern reduziert.

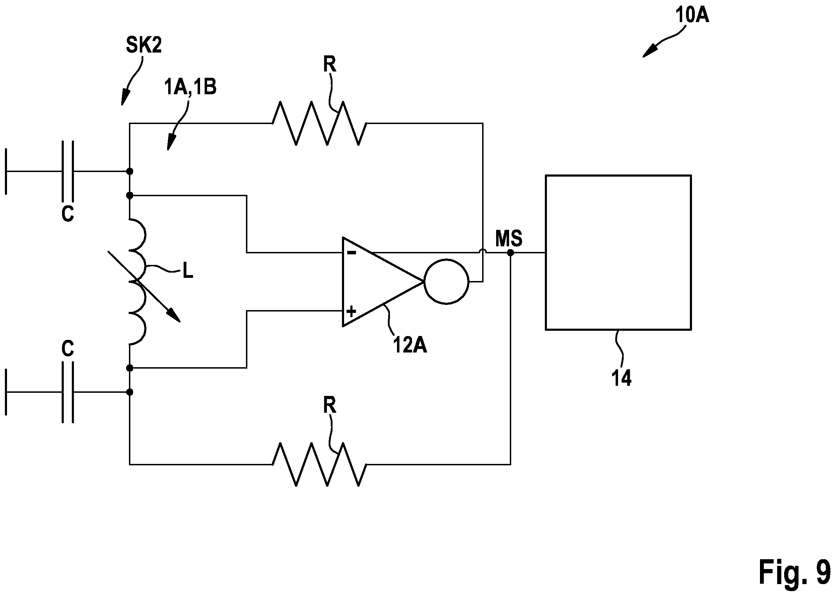

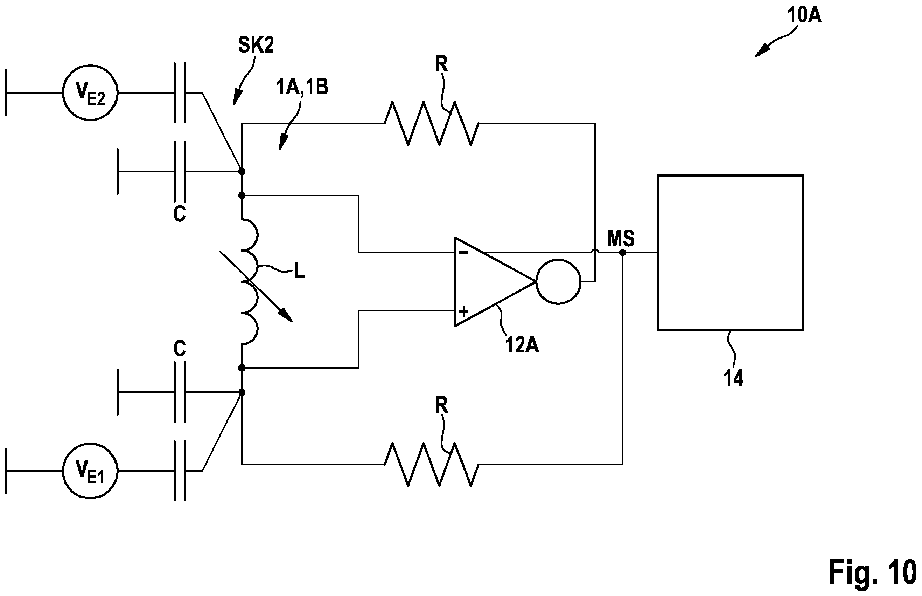

Durch die oben beschriebenen Spulenanordnungen 1, 1A, 1B kann die durch magnetische Schleifen Hy1, Hy2, Hy3, Hy4, Hx1, Hx2, Hx3, Hx4 induzierte Störspannungen V_{H} nahezu auf "Null" reduziert werden. Ein verbleibendes Problem ist die elektrische Asymmetrie der Messanordnung 10 mit unterschiedlichen Impedanzen an den Klemmen der Messspulenanordnung L. Fig. 9, 10 zeigen jeweils eine verbesserte Messanordnung 10A mit symmetrischen Impedanzen an den Klemmen der Messspulenanordnung L. Fig. 10 zeigt analog zu Fig. 2 die induzierten Störspannungen V_{H}, V_{E1}, V_{E2} im Schaltbild der Messanordnung 10A. Wie aus Fig. 9 und 10 ersichtlich ist, umfasst das dargestellte zweite Ausführungsbeispiel einer erfindungsgemäßen Messanordnung 10A einen Verstärker 12A und einen Schwingkreis SK2, welcher mindestens eine Kapazität C und eine Messspulenanordnung L umfasst. Ein Ausgabesignal des Verstärkers 12A repräsentiert als Messsignal MS eine Induktivität und/oder Induktivitätsänderung der Messspulenanordnung L. Im dargestellten Ausführungsbeispiel ist der Schwingkreis SK2 als symmetrisches Pi-LC-Netzwerk mit zwei gleichgroßen Kapazitäten C ausgeführt, zwischen welchen die Messspulenanordnung L angeordnet ist. Der Verstärker 12A ist als Differenzverstärker ausgeführt, dessen invertierender Eingang mit einer ersten Seite des Schwingkreises SK2 verbunden ist und dessen nicht invertierender Eingang mit einer zweiten Seite des Schwingkreises SK2 verbunden ist. Ein invertierender Ausgang ist über einen ersten ohmschen Widerstand R mit der ersten Seite des Schwingreises SK2 rückgekoppelt, und ein nichtinvertierender Ausgang gibt das Messsignal MS aus, welches über einen zweiten ohmschen Widerstand R an die zweite Seite des Schwingkreises SK2 rückgekoppelt ist. Im dargestellten Ausführungsbeispiel misst ein Zähler 14 eine Frequenz des Messsignals MS.

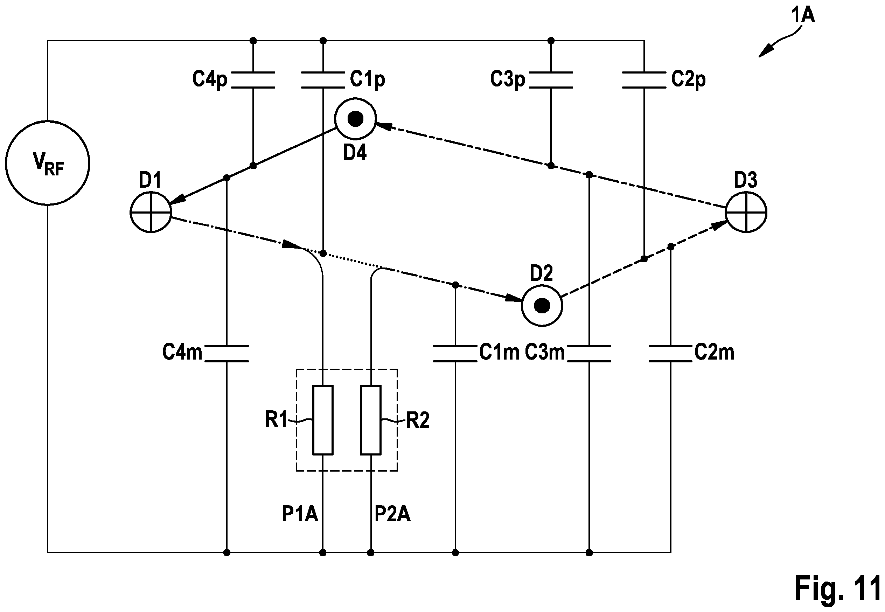

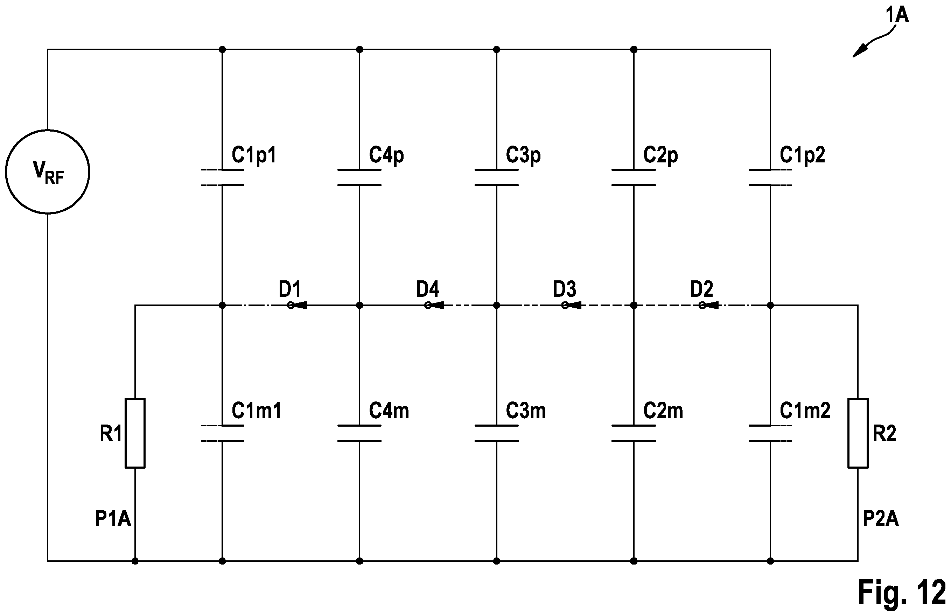

Fig. 11 und 12 zeigen jeweils eine schematische Darstellung der symmetrischen Spulenanordnung 1A aus Fig. 7 mit den als Kondensatoren C1m, C2m, C3m, C4m, C1p, C2p, C3p, C4p dargestellten elektrischen Störfeldern. Die elektrische Auswerteschaltung an den beiden Spulenanschlüssen P1A und P2A ist durch zwei ohmsche Widerstände R1, R2 vereinfacht dargestellt. Die Kondensatoren C1m, C2m, C3m, C4m, C1p, C2p, C3p, C4p stellen die kapazitive Kopplung zwischen einem externen Hochfrequenzfeld (V_{RF}) und der Spulenanordnung 1A dar. Die in Fig. 12 dargestellte abgerollte Spulenanordnung 1A zeigt die vollständige Symmetrie und Kompensation der externen elektrischen Felder, wenn die Messanordnung 10A gemäß Fig. 9 und 10 verwendet wird, wobei sich die elektrischen Störfelder, welche durch die Kondensatoren C1p, C1m repräsentiert sind, symmetrisch auf die Spulenanschlüsse P1A, P2A aufteilen, wie die Kondensatoren C1p1, C1p2, C1m1, C1m2 zeigen. Die in Fig. 11 und 12 dargestellten Kondensatoren C1m, C2m, C3m, C4m symbolisieren die Kopplung zur Abschirmung und die Kondensatoren C1p, C2p, C3p, C4p symbolisieren die Kopplung zur Hochfrequenzquelle V_{RF}. Hierbei sind die elektrischen Verbindungen, welche über die "größeren" Kapazitäten" C2p, C4p mit der Hochfrequenzquelle V_{RF} gekoppelt sind, näher an der Hochfrequenzquelle V_{RF} angeordnet als die elektrischen Verbindungen, welche über die "kleineren" Kapazitäten" C1p, C3p mit der Hochfrequenzquelle V_{RF} gekoppelt sind. Analog sind die elektrischen Verbindungen, welche über die "größeren" Kapazitäten" C1m, C3m mit der Abschirmung gekoppelt sind, näher an der Abschirmung angeordnet als die elektrischen Verbindungen, welche über die "kleineren" Kapazitäten" C2m, C4m mit der Abschirmung gekoppelt sind. Die externen HF-Feld Paare ähnliche Signale in R1 und R2. Durch die Messanordnung 10A werden die elektrischen Störfelder hier vollständig kompensiert.

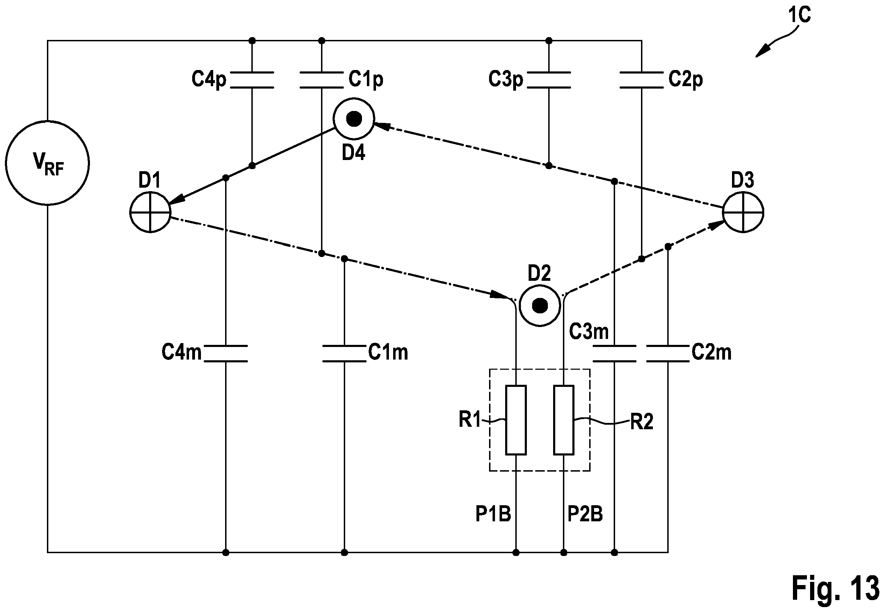

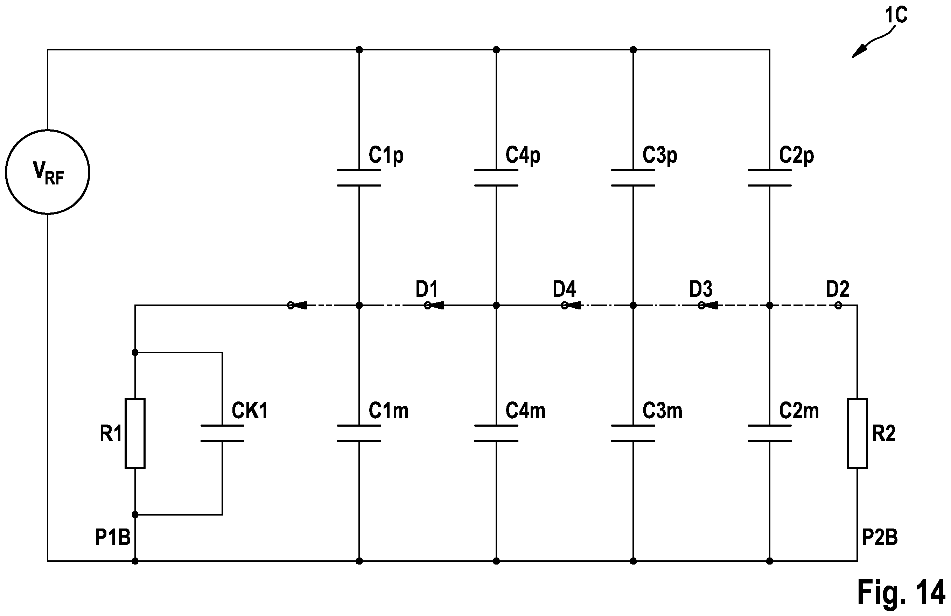

Fig. 13 und 14 zeigen die Kompensation von als Kondensatoren C1m, C2m, C3m, C4m, C1p, C2p, C3p, C4p dargestellten elektrischen Störfeldern in einem nicht idealen Fall. Fig. 13 und 14 zeigen jeweils eine schematische Darstellung einer nicht vollständig symmetrischen Spulenanordnung 1C. Analog zur Spulenanordnung aus Fig. 7 weist die Spulenanordnung 1C aufgrund der kombinieten Nutzung der zweiten Durchkontaktierung D2 eine Asymmetrie auf, wie aus Fig. 14 ersichtlich ist. Die beiden Spulenanschlüsse P1B und P2B sind analog zur Spulenanordnung 1A aus Fig. 11 und 12 an zwei ohmsche Widerstände R1, R2 angeschlossen. Die Kondensatoren C1m, C2m, C3m, C4m, C1p, C2p, C3p, C4p stellen analog zur Spulenanordnung 1A aus Fig. 11 und 12 die kapazitive Kopplung zwischen einem externen Hochfrequenzfeld (V_{RF}) und der Spulenanordnung 1C dar. Die in Fig. 14 dargestellte abgerollte Spulenanordnung 1C zeigt die Asymmetrie der externen elektrischen Felder, wenn die Messanordnung 10A gemäß Fig. 9 und 10 verwendet wird. Dennoch ist eine teilweise Kompensation der externen elektrischen Störfelder möglich. So können die Spulenanschlüsse P1B und P2B beispielsweise durch einen zusätzlichen Kompensationskondensator CK1 oder andere diskrete Elemente in ein Gleichgewicht gebracht werden.

## Patentansprüche

1. Spulenanordnung (1, 1A, 1B, 1C) mit einer Spulenwicklung und einer mehrlagigen Leiterplatte (3), wobei die Spulenwicklung mehrere Schleifen (S1, S2, S3, S4) aufweist, welche in verschiedenen Lagen (LS1, LS2) der Leiterplatte (3) angeordnet sind und ein magnetische Hauptfeld (Hz) mit einer senkrecht zu einer Hauptebene (x-y) der Leiterplatte (3) stehenden Hauptrichtung (z) ausbilden, und wobei die in verschiedenen Lagen (LS1, LS2) angeordneten Schleifen (S1, S2, S3, S4) über mindestens eine Durchkontaktierung (D1, D2, D3, D4) elektrisch miteinander verbunden sind, wobei die Leiterplatte (3) vier Durchkontaktierungen (D1, D2, D3, D4) oder ein ganzzahliges Vielfaches von vier Durchkontaktierungen (D1, D2, D3, D4) aufweist, welche zwischen den Schleifen (S1, S2, S3, S4) der Spulenwicklung eine gleiche Anzahl von Abwärtsstrompfaden (V1, V3) und Aufwärtsstrompfaden (V2, V4) ausbilden, **dadurch gekennzeichnet, dass** jeweils zwei Durchkontaktierungen (D1, D3; D2, D4) mit gleicher Strompfadrichtung punktsymmetrisch zu einem gemeinsamen Spiegelpunkt (S) angeordnet sind, so dass magnetische Schleifen (Hy1, Hy2, Hx1, Hx2), welche sich in senkrecht zur Hauptebene (x-y) angeordneten Nebenebenen ((x-z),(y-z)) der Leiterplatte (3) ausbilden, entgegengesetzte Richtungen aufweisen und sich gegenseitig kompensieren.

2. Spulenanordnung nach Anspruch 1, **dadurch gekennzeichnet, dass** die mindestens vier Durchkontaktierungen (D1, D2, D3, D4) entlang einer gemeinsamen Geraden angeordnet sind.

3. Spulenanordnung nach Anspruch 1, **dadurch gekennzeichnet, dass** die paarweise punktsymmetrisch angeordneten Durchkontaktierungen (D1, D3; D2, D4) am Schwerpunkt der Spulenanordnung als Spiegelpunkt (S) gespiegelt sind, welcher durch einen gemeinsamen Schnittpunkt zwischen Verbindungsgeraden (A13, A24) der paarweise punktsymmetrisch angeordneten Durchkontaktierungen (D1, D3; D2, D4) vorgegeben ist.

4. Spulenanordnung nach Anspruch 3, **dadurch gekennzeichnet, dass** ein Winkel (a) zwischen zwei Verbindungsgeraden (A13, A24) einen beliebigen Wert zwischen 0 und 360° aufweist.

5. Spulenanordnung nach einem der Ansprüche 1 bis 4, **dadurch gekennzeichnet, dass** die Spulenwicklung jeweils eine als Abwärtsstrompfad (V1, V3) ausgebildete Durchkontaktierung (D1, D3) mit einer als Aufwärtsstrompfad (V2, V4) ausgebildeten Durchkontaktierung (D2, D4) und eine als Aufwärtsstrompfad (V2, V4) ausgebildete Durchkontaktierung (D2, D4) mit einer als Abwärtsstrompfad (V1, V3) ausgebildeten Durchkontaktierung (D1, D3) elektrisch verbindet.

6. Spulenanordnung nach Anspruch 5, **dadurch gekennzeichnet, dass** zumindest eine erste Schleife (S1), welche in einer ersten Lage (LS1) der Leiterplatte (3) eine als Abwärtsstrompfad (V1) ausgebildete erste Durchkontaktierung (D1) mit einer als Aufwärtsstrompfad (V2) ausgebildeten zweiten Durchkontaktierung (D2) elektrisch verbindet, und zumindest eine zweite Schleife (S2), welche in einer zweiten Lage (LS2) der Leiterplatte (3) die als Aufwärtsstrompfad (V2) ausgebildete zweite Durchkontaktierung (D2) mit einer als Abwärtsstrompfad (V3) ausgebildeten dritten Durchkontaktierung (D3) elektrisch verbindet, und zumindest eine dritte Schleife (S3), welche in der ersten Lage (LS1) der Leiterplatte (3) die als Abwärtsstrompfad (V3) ausgebildete dritte Durchkontaktierung (D3) mit einer als Aufwärtsstrompfad (V4) ausgebildeten vierten Durchkontaktierung (D4) elektrisch verbindet, und zumindest eine vierte Schleife (S4), welche in der zweiten Lage (LS2) der Leiterplatte (3) die als Aufwärtsstrompfad (V4) ausgebildete vierte Durchkontaktierung (D4) mit der als Abwärtsstrompfad (V1) ausgebildeten ersten Durchkontaktierung (D1) elektrisch verbindet, die gleiche Orientierung aufweisen.

7. Spulenanordnung nach Anspruch 6, **dadurch gekennzeichnet, dass** die elektrischen Verbindungen zwischen den als Abwärtsstrompfade (V1, V3) ausgebildeten Durchkontaktierungen (D1, D3) und den als Aufwärtsstrompfade (V2, V4) ausgebildeten Durchkontaktierungen (D2, D4) und/oder zwischen den als Aufwärtsstrompfade (V1, V3) ausgebildeten Durchkontaktierungen (D1, D3) und den als Abwärtsstrompfade (V2, V4) ausgebildeten Durchkontaktierungen (D2, D4) eine beliebige Anzahl von Schleifen aufweisen, wobei die Schleifen keinen Schnittpunkt mit der Verbindungslinie (A24) zwischen den als Aufwärtsstrompfade (V2, V3) ausgebildeten Durchkontaktierungen (D2, D4) aufweisen.

8. Spulenanordnung nach einem der Ansprüche 1 bis 7, **dadurch gekennzeichnet, dass** die Leiterplatte (3) ein Anschlussterminal mit vier Anschlusskontaktierungen (D5, D6, D7, D8) aufweist, welche jeweils paarweise punktsymmetrisch zum gemeinsamen Spiegelpunkt (S) angeordnet sind, wobei zwei Anschlusskontaktierungen (D5, D7) als Abwärtsstrompfade (V5, V7) und zwei Anschlusskontaktierungen (D6, D8) als Aufwärtsstrompfade (V6, V8) ausgebildet sind.

9. Spulenanordnung nach Anspruch 8, **dadurch gekennzeichnet, dass** eine als Abwärtsstrompfad (V5) ausgeführte erste Anschlusskontaktierung (D5) und eine als Aufwärtsstrompfad (V6) ausgebildete zweite Anschlusskontaktierung (D6) jeweils als Spulenanschlüsse (P1A, P2A, P1B, P2B) in einer dritten Lage (LS3) ausgebildet sind, wobei eine als Abwärtsstrompfad (V7) ausgeführte dritte Anschlusskontaktierung (D7) und eine als Aufwärtsstrompfad (V8) ausgebildete vierte Anschlusskontaktierung (D8) jeweils als Kompensationskontaktierung ausgebildet sind.

10. Spulenanordnung nach Anspruch 9, **dadurch gekennzeichnet, dass** die erste Anschlusskontaktierung (D5) und die zweite Anschlusskontaktierung (D6) in eine erste Verbindung (D12) zwischen zwei Durchkontaktierungen (D1, D2) eingeschleift sind und diese unterbrechen, wobei die dritte Anschlusskontaktierung (D7) und die vierte Anschlusskontaktierung (D8) in eine korrespondierende am gemeinsamen Spiegelpunkt gespiegelte Verbindung (D34) zwischen zwei Durchkontaktierungen (D3, D4) eingeschleift sind und diese unterbrechen, wobei die dritte Anschlusskontaktierung (D7) und die vierte Anschlusskontaktierung (D8) in einer dritten Lage (LS3) elektrisch miteinander verbunden sind.

11. Spulenanordnung nach einem der Ansprüche 8 bis 10, **dadurch gekennzeichnet, dass** das Anschlussterminal vier zusätzliche Durchkontaktierungen aufweist, welche die Anschlusskontaktierungen (D5, D6, D7, D8) ausbilden.

12. Spulenanordnung nach einem der Ansprüche 8 bis 10, **dadurch gekennzeichnet, dass** das Anschlussterminal zwei zusätzliche Durchkontaktierungen aufweist, wobei eine zusätzliche Durchkontaktierung und eine Durchkontaktierung (D1) der Spulenwicklung jeweils eine Anschlusskontaktierung (D5, D8) ausbilden, und eine zusätzliche Durchkontaktierung und eine Durchkontaktierung (D3) der Spulenwicklung jeweils eine Kompensationskontaktierung (D7, D8) ausbilden.

13. Messanordnung (10, 10A) mit einem Verstärker (12, 12A) und einem Schwingkreis (SK1, SK2), welcher mindestens eine Kapazität (C, C1, C2) und eine Messspulenanordnung (L) umfasst, wobei ein Ausgabesignal des Verstärkers (12, 12A) als Messsignal (MS) eine Induktivität und/oder Induktivitätsänderung der Messspulenanordnung (L) repräsentiert, **dadurch gekennzeichnet, dass** die Messspulenanordnung (L) als Spulenanordnung (1, 1A, 1B, 1C) nach einem der Ansprüche 1 bis 12 ausgeführt ist.

14. Messanordnung nach Anspruch 13, **dadurch gekennzeichnet, dass** der Schwingkreis (SK1, SK2) als Pi-LC-Oszillator mit zwei Kapazitäten (C, C1, C2) ausgeführt ist, zwischen welchen die Messspulenanordnung (L) angeordnet ist.

15. Messanordnung nach Anspruch 13 oder 14, **dadurch gekennzeichnet, dass** der Verstärker (12) als Inverter ausgeführt ist, dessen Eingang mit einer ersten Seite des Schwingkreises (SK1) verbunden ist und dessen invertierender Ausgang das Messsignal (MS) ausgibt, welches über einen ohmschen Widerstand (R) an eine zweite Seite des Schwingkreises (SK1) rückgekoppelt ist.

16. Messanordnung nach Anspruch 13 oder 14, **dadurch gekennzeichnet, dass** der Verstärker (12A) als Differenzverstärker ausgeführt ist, dessen invertierender Eingang mit einer ersten Seite des Schwingkreises (SK2) verbunden ist und dessen nicht invertierender Eingang mit einer zweiten Seite des Schwingkreises (SK2) verbunden ist, wobei ein invertierender Ausgang über einen ersten ohmschen Widerstand (R) mit der ersten Seite des Schwingreises (SK2) rückgekoppelt ist, und ein nichtinvertierender Ausgang das Messsignal (MS) ausgibt, welches über einen zweiten ohmschen Widerstand (R) an die zweite Seite des Schwingkreises (SK2) rückgekoppelt ist.

17. Messanordnung nach einem der Ansprüche 13 bis 16, **dadurch gekennzeichnet, dass** ein Zähler (14) eine Frequenz des Messsignals (MS) misst.

## Claims

1. Coil assembly (1, 1A, 1B, 1C) having a coil winding and a multilayered printed circuit board (3), wherein the coil winding has a plurality of loops (S1, S2, S3, S4), which are arranged in different layers (LS1, LS2) of the printed circuit board (3) and form a main magnetic field (Hz) having a main direction (z) perpendicular to a main plane (x-y) of the printed circuit board (3), and wherein the loops (S1, S2, S3, S4) arranged in different layers (LS1, LS2) are connected electrically to one another by means of at least one via (D1, D2, D3, D4), wherein the printed circuit board (3) has four vias (D1, D2, D3, D4) or an integral multiple of four vias (D1, D2, D3, D4), which, between the loops (S1, S2, S3, S4) of the coil winding, form an identical number of downward current paths (V1, V3) and upward current paths (V2, V4), **characterized in that** in each case two vias (D1, D3; D2, D4) with the same current path direction are arranged point-symmetrically with respect to a common mirror point (S), with the result that magnetic loops (Hy1, Hy2, Hx1, Hx2) which are formed in secondary planes ((x-z), (y-z)) of the printed circuit board (3) which are arranged perpendicular to the main plane (x-y) have opposite directions and compensate for one another.

2. Coil assembly according to Claim 1, **characterized in that** the at least four vias (D1, D2, D3, D4) are arranged along a common straight line.

3. Coil assembly according to Claim 1, **characterized in that** the vias (D1, D3; D2, D4) arranged point-symmetrically in pairs are mirrored at the center of gravity of the coil assembly as mirror point (S), which is predetermined by a common point of intersection between connecting straight lines (A13, A24) of the vias (D1, D3; D2, D4) arranged point-symmetrically in pairs.

4. Coil assembly according to Claim 3, **characterized in that** an angle (a) between two connecting straight lines (A13, A24) has any desired value between 0 and 360°.

5. Coil assembly according to one of Claims 1 to 4, **characterized in that** the coil winding electrically connects in each case a via (D1, D3) in the form of a downward current path (V1, V3) to a via (D2, D4) in the form of an upward current path (V2, V4) and a via (D2, D4) in the form of an upward current path (V2, V4) to a via (D1, D3) in the form of a downward current path (V1, V3).

6. Coil assembly according to Claim 5, **characterized in that** at least one first loop (S1), which, in a first layer (LS1) of the printed circuit board (3), electrically connects a first via (D1) in the form of a downward current path (V1) to a second via (D2) in the form of an upward current path (V2), and at least one second loop (S2), which, in a second layer (LS2) of the printed circuit board (3), electrically connects the second via (D2) in the form of an upward current path (V2) to a third via (D3) in the form of a downward current path (V3), and at least one third loop (S3), which, in the first layer (LS1) of the printed circuit board (3), electrically connects the third via (D3) in the form of a downward current path (V3) to a fourth via (D4) in the form of an upward current path (V4), and at least one fourth loop (S4), which, in the second layer (LS2) of the printed circuit board (3), electrically connects the fourth via (D4) in the form of an upward current path (V4) to the first via (D1) in the form of a downward current path (V1), have the same orientation.

7. Coil assembly according to Claim 6, **characterized in that** the electrical links between the vias (D1, D3) in the form of downward current paths (V1, V3) and the vias (D2, D4) in the form of upward current paths (V2, V4) and/or between the vias (D1, D3) in the form of upward current paths (V1, V3) and the vias (D2, D4) in the form of downward current paths (V2, V4) have any desired number of loops, wherein the loops do not have a point of intersection with the connecting line (A24) between the vias (D2, D4) in the form of upward current paths (V2, V3).

8. Coil assembly according to one of Claims 1 to 7, **characterized in that** the printed circuit board (3) has a connection terminal having four connection contacts (D5, D6, D7, D8), which are each arranged point-symmetrically in pairs with respect to the common mirror point (S), wherein two connection contacts (D5, D7) are in the form of downward current paths (V5, V7) and two connection contacts (D6, D8) are in the form of upward current paths (V6, V8).

9. Coil assembly according to Claim 8, **characterized in that** a first connection contact (D5) embodied as a downward current path (V5) and a second connection contact (D6) in the form of an upward current path (V6) are each in the form of coil connections (P1A, P2A, P1B, P2B) in a third layer (LS3), wherein a third connection contact (D7) embodied as a downward current path (V7) and a fourth connection contact (D8) in the form of an upward current path (V8) are each in the form of a compensation contact.

10. Coil assembly according to Claim 9, **characterized in that** the first connection contact (D5) and the second connection contact (D6) are looped into a first link (D12) between two vias (D1, D2) and interrupt said link, wherein the third connection contact (D7) and the fourth connection contact (D8) are looped into a corresponding link (D34), mirrored at the common mirror point, between two vias (D3, D4) and interrupt said link, wherein the third connection contact (D7) and the fourth connection contact (D8) are connected electrically to one another in a third layer (LS3).

11. Coil assembly according to one of Claims 8 to 10, **characterized in that** the connection terminal has four additional vias, which form the connection contacts (D5, D6, D7, D8).

12. Coil assembly according to one of Claims 8 to 10, **characterized in that** the connection terminal has two additional vias, wherein an additional via and a via (D1) of the coil winding each form a connection contact (D5, D8), and an additional via and a via (D3) of the coil winding each form a compensation contact (D7, D8).

13. Measuring assembly (10, 10A) having an amplifier (12, 12A) and a resonant circuit (SK1, SK2), which comprises at least one capacitance (C, C1, C2) and a measuring coil assembly (L), wherein an output signal of the amplifier (12, 12A) represents, as measurement signal (MS), an inductance and/or change in inductance of the measuring coil assembly (L), **characterized in that** the measuring coil assembly (L) is embodied as a coil assembly (1, 1A, 1B, 1C) according to one of Claims 1 to 12.

14. Measuring assembly according to Claim 13, **characterized in that** the resonant circuit (SK1, SK2) is embodied as a Pi-LC oscillator having two capacitances (C, C1, C2), between which the measuring coil assembly (L) is arranged.

15. Measuring assembly according to Claim 13 or 14, **characterized in that** the amplifier (12) is embodied as an inverter, whose input is connected to a first side of the resonant circuit (SK1), and whose inverting output outputs the measurement signal (MS), which is fed back to a second side of the resonant circuit (SK1) via a nonreactive resistance (R) .

16. Measuring assembly according to Claim 13 or 14, **characterized in that** the amplifier (12A) is embodied as a differential amplifier, whose inverting input is connected to a first side of the resonant circuit (SK2), and whose noninverting input is connected to a second side of the resonant circuit (SK2), wherein an inverting output is fed back to the first side of the resonant circuit (SK2) via a first nonreactive resistance (R), and a noninverting output outputs the measurement signal (MS), which is fed back to the second side of the resonant circuit (SK2) via a second nonreactive resistance (R) .

17. Measuring assembly according to one of Claims 13 to 16, **characterized in that** a meter (14) measures a frequency of the measurement signal (MS).

## Revendications

1. Ensemble de bobine (1, 1A, 1B, 1C) présentant un enroulement de bobine et une carte de circuit (3) en plusieurs couches, l'enroulement de bobine présentant plusieurs boucles (S1, S2, S3, S4) disposées sur différentes couches (LS1, LS2) de la carte de circuit (3) et produisant un champ magnétique principal (Hz) dont la direction principale (z) est orthogonale au plan principal (x-y) de la carte de circuit (3), les boucles (S1, S2, S3, S4) disposées sur des couches (LS1, LS2) différentes étant raccordées électriquement les unes aux autres par un ou plusieurs contacts transverse (D1, D2, D3, D4), la carte de circuit (3) présentant quatre contacts transverse (D1, D2, D3, D4) ou un multiple entier de quatre contacts transverse (D1, D2, D3, D4) formant un même nombre de parcours de courant descendant (V1, V3) et de parcours de courant montant (V2, V4) entre les boucles (S1, S2, S3, S4),
**caractérisé en ce que** deux traverses de mise en contact (D1, D3 ; D2, D4) à même direction du courant sont disposées symétriquement par rapport à un point miroir (S) commun, de telle sorte que les boucles magnétiques (Hy1, Hy2, Hx1, Hx2) formées dans des plans secondaires ((x-z), (y-z)) de la carte de circuit (3) disposés orthogonalement par rapport au plan principal (x-y) aient des directions opposées et se compensent mutuellement.

2. Ensemble de bobine selon la revendication 1, **caractérisé en ce que** les quatre ou plusieurs traverses de mise en contact (D1, D2, D3, D4) sont disposées le long d'un droite commune.

3. Ensemble de bobine selon la revendication 1, **caractérisé en ce que** les traverses de mise en contact (D1, D3 ; D2, D4) disposées en paires symétriques sont symétriques par rapport au centre de masse qui coïncide avec le centre de symétrie (S) de l'ensemble de bobine et qui est prédéterminé par un point d'intersection entre des droites (A13, A24) reliant les traverses de mise en contact (D1, D3 ; D2, D4) disposées en paires symétriques.

4. Ensemble de bobine selon la revendication 3, **caractérisé en ce que** l'angle (a) formé entre deux droites (A13, A24) peut prendre toute valeur comprise entre 0 et 360°.

5. Ensemble de bobine selon l'une des revendications 1 à 4, **caractérisé en ce que** l'enroulement de bobine raccorde électriquement chaque traverse de mise en contact (D1, D3) configurée comme parcours de courant descendant (V1, V3) à une traverse de mise en contact (D2, D4) configurée comme parcours de courant montant (V2, V4) et une traverse de mise en contact (D2, D4) configurée comme parcours de courant montant (V2, V4) à une traverse de mise en contact (D1, D3) configurée comme parcours de courant descendant (V1, V3).

6. Ensemble de bobine selon la revendication 5, **caractérisé en ce qu'**une ou plusieurs premières boucles (S1) qui raccordent électriquement sur une première couche (LS1) de la carte de circuit (3) une première traverse de mise en contact (D1) configurée comme parcours de courant descendant (V1) à une deuxième traverse de mise en contact (D2) configurée comme parcours de courant montant (V2), une ou plusieurs deuxièmes boucles (S2) qui raccordent électriquement sur une deuxième couche (LS2) de la carte de circuit (3) la deuxième traverse de mise en contact (D2) configurée comme parcours de courant montant (V2) à une troisième traverse de mise en contact (D3) configurée comme parcours de courant descendant (V3), une ou plusieurs troisièmes boucles (S3) qui raccordent électriquement dans la première couche (LS1) de la carte de circuit (3) la troisième traverse de mise en contact (D3) configurée comme parcours de courant descendant (V3) à une quatrième traverse de mise en contact (D4) configurée comme parcours de courant montant (V4) et une ou plusieurs quatrièmes couches (S4) qui raccordent électriquement dans la deuxième couche (LS2) de la carte de circuit (3) la quatrième traverse de mise en contact (D4) configurée comme parcours de courant montant (V4) à la première traverse de mise en contact (D1) configurée comme parcours de courant descendant (V1) ont la même orientation.

7. Ensemble de bobine selon la revendication 7, **caractérisé en ce que** les raccordements électriques entre les traverses de mise en contact (D1, D3) configurées comme parcours de courant descendant (V1, V3) et les traverses de mise en contact (D2, D4) configurées comme parcours de courant montant (V2, V4) et/ou entre les traverses de mise en contact (D1, D3) configurées comme parcours de courant montant (V1, V3) et les traverses de mise en contact (D2, D4) configurées comme parcours de courant descendant (V2, V4) présentent un nombre quelconque de boucles, les boucles n'ayant pas de points d'intersection avec la ligne de liaison (A24) qui relie les traverses de mise en contact (D2, D4) configurées comme parcours de courant montant (V2, V3).

8. Ensemble de bobine selon l'une des revendications 1 à 7, **caractérisé en ce que** la carte de circuit (3) présente une borne de raccordement dotée de quatre contacts de raccordement (D5, D6, D7, D8) disposés en paires symétriques par rapport au centre de symétrie (S) commun, deux contacts de raccordement (D5, D7) étant configurés comme parcours de courant descendant (V5, V7) et deux contacts de raccordement (D6, D8) étant configurés comme parcours de courant montant (V6, V8).

9. Ensemble de bobine selon la revendication 8, **caractérisé en ce qu'**un premier contact de raccordement (D5) configuré comme parcours de courant descendant (V5) et un deuxième contact de raccordement (D6) configuré comme parcours de courant montant (V6) sont configurés comme raccordements de bobine (P1A, P2A, P1B, P2B) dans une troisième couche (LS3), un troisième contact de raccordement (D7) configuré comme parcours de courant descendant (V7) et un quatrième contact de raccordement (D8) configuré comme parcours de courant montant (V8) étant tous configurés comme contact de compensation.

10. Ensemble de bobine selon la revendication 9, **caractérisé en ce que** le contact de raccordement (D5) et le contact de raccordement (D6) sont incorporés dans une première liaison (D12) entre deux traverses de mise en contact (D1, D2) et interrompent cette liaison, le contact de raccordement (D7) et le contact de raccordement (D8) étant incorporés dans une liaison correspondante (D34) symétrique par rapport au centre de symétrie commun et reliant deux traverses de mise en contact (D3, D4), le contact de raccordement (D7) et le contact de raccordement (D8) étant raccordés électriquement dans une troisième couche (LS3).

11. Ensemble de bobine selon l'une des revendications 8 à 10, **caractérisé en ce que** la borne de raccordement présente quatre traverses de mise en contact supplémentaires qui forment les contact de raccordement (D5, D6, D7, D8).

12. Ensemble de bobine selon l'une des revendications 8 à 10, **caractérisé en ce que** la borne de raccordement présente deux traverses de mise en contact supplémentaires, une traverse de mise en contact supplémentaire et une traverse de mise en contact (D1) de l'enroulement de bobine formant un contact de raccordement (D5, D8) respectif et une traverse de mise en contact supplémentaire et une traverse de mise en contact (D3) de l'enroulement de bobine formant un contact de compensation (D7, D8) respectif.

13. Ensemble de mesure (10, 10A) présentant un amplificateur (12, 12A) et un circuit oscillant (SK1, SK2) qui comporte une ou plusieurs capacités (C, C1, C2) et un ensemble (L) de bobine de mesure, le signal de sortie de l'amplificateur (12, 12A) qui forme le signal de mesure (MS) représentant l'inductance ou une modification de l'inductance de l'ensemble (L) de bobine de mesure, **caractérisé en ce que** l'ensemble (L) de bobine de mesure est configuré comme ensemble de bobine (1, 1A, 1B, 1C) selon l'une des revendications 1 à 12.

14. Ensemble de mesure selon la revendication 13, **caractérisé en ce que** le circuit oscillant (SK1, SK2) est configuré comme oscillateur Pi-LC à deux capacités (C, C1, C2) entre lesquelles est disposé l'ensemble (L) de bobine de mesure.

15. Ensemble de mesure selon l'une des revendications 13 ou 14, **caractérisé en ce que** l'amplificateur (12) est configuré comme inverseur dont l'entrée est raccordée au premier côté du circuit oscillant (SK1) et dont l'entrée inversante délivre le signal de mesure (MS) qui est renvoyé par l'intermédiaire d'une résistance ohmique (R) au deuxième côté du circuit oscillant (SK1).

16. Ensemble de mesure selon l'une des revendications 13 ou 14, **caractérisé en ce que** l'amplificateur (12A) est configuré comme amplificateur différentiel dont l'entrée inversante est raccordée au premier côté du circuit oscillant (SK2) et dont l'entrée non inversante est raccordée au deuxième côté du circuit oscillant (SK2), la sortie inversante étant raccordée par l'intermédiaire d'une première résistance ohmique (R) au premier côté du circuit oscillant (SK2) et la sortie non inversante délivrant le signal de mesure (MS) qui est renvoyé par l'intermédiaire d'une deuxième résistance ohmique (R) au deuxième côté du circuit oscillant (SK2).

17. Ensemble de mesure selon l'une des revendications 13 à 16, **caractérisé en ce qu'**un compteur (14) mesure la fréquence du signal de mesure (MS).
